# EUROPÄISCHE PATENTSCHRIFT

(11) **EP 2 186 922 B1**
(45) Veröffentlichungstag und Bekanntmachung des Hinweises auf die Patenterteilung: **27.02.2013**
(21) Anmeldenummer: 09013314.1
(22) Anmeldetag: 21.10.2009
(51) Int. Cl.: C23C 16/30, C23C 16/509, C23C 16/448, C04B 14/38, C23C 16/54

(54) **Verfahren zum Abscheiden einer Nanokomposit-Schicht auf einem Substrat mittels chemischer Dampfabscheidung**
Method for deposting a nanocomposite layer on a substrate using chemical vapor deposition
Procédé de dépot d'une couche nanocomposite sur un substrat à l'aide d'une procédé de dépôt chimique en phase vapeur

(30) Priorität: 13.11.2008 DE 102008056968
(43) Veröffentlichungstag der Anmeldung: 19.05.2010
(73) Patentinhaber: Fraunhofer-Gesellschaft zur Förderung der angewandten Forschung e.V., 80686 München (DE)
(72) Erfinder: Fahland, Matthias, 01259 Dresden (DE); Vogt, Tobias, 02796 Kurort Jonsdorf (DE); Günther, Steffen, 01309 Dresden (DE); Schiller, Nicolas, 01833 Stolpen OT Helmsdorf (DE)

(56) Entgegenhaltungen:
- WO-A1-2008/074388
- WO-A2-2007/051994
- HOU X ET AL: "Synthesis of Cr2O3-based nanocomposite coatings with incorporation of inorganic fullerene-like nanoparticles" THIN SOLID FILMS, ELSEVIER-SEQUOIA S.A. LAUSANNE, CH, Bd. 516, Nr. 23, 1. Oktober 2008 (2008-10-01), Seiten 8620-8624, XP025347470 ISSN: 0040-6090 [gefunden am 2008-06-20]
- HOU X ET AL: "Processing and applications of aerosol-assisted chemical vapor deposition" CHEMICAL VAPOR DEPOSITION 2006 WILEY-VCH VERLAG DE, Bd. 12, Nr. 10, 2006, Seiten 583-596, XP002570668
- HAHN B-D ET AL: "multi-walled carbon nanotube-reinforced hydroxyapatite coating on ti substrates by aerosol deposition" JOURNAL OF THE KOREAN CERAMIC SOCIETY OCTOBER 2008 KOREAN CERAMIC SOCIETY KOR, Bd. 45, Nr. 10, Oktober 2008 (2008-10), Seiten 610-617, XP002570669
- HAHN B-D ET AL: "Effects of Zr/Ti ratio and post-annealing temperature on the electrical properties of lead zirconate titanate (PZT) thick films fabricated by aerosol deposition" JOURNAL OF MATERIALS RESEARCH JANUARY 2008 MATERIALS RESEARCH SOCIETY US, Bd. 23, Nr. 1, Januar 2008 (2008-01), Seiten 226-235, XP002570670

## Beschreibung

Die Erfindung betrifft ein Verfahren und eine Vorrichtung zum Abscheiden einer Nanokomposit-Schicht auf einem Substrat, wobei der Abscheideprozess auf einer chemischen Reaktion unter Vakuumbedingungen beruht.

Nanokomposite sind Materialen, die sich aus nanoskaligen Partikeln zusammensetzen bzw. in welche nanoskalige Partikel (nachfolgend auch Nanopartikel genannt) eingebettet sind. Die Bedeutung von Nanopartikeln resultiert vornehmlich aus dem günstigen Verhältnis von Oberfläche zu Volumen. Je geringer der mittlere Durchmesser eines Partikels ist, umso größer wird das Verhältnis von Oberfläche zu Volumen.

Ein Nanopartikel besteht aus wenigen bis mehreren Tausend Atomen, wobei sich ein großer Anteil der Atome an der Oberfläche des Partikels befindet. Diese sich an der Oberfläche eines Nanopartikels befindlichen Atome verfügen über eine geringere Anzahl unmittelbarer Nachbaratome als im Inneren des Nanopartikels und weisen daher so genannte ungesättigte Bindungen auf, welche wiederum Ursache für die erhöhte Reaktivität der Partikeloberfläche sind. Diese hohe Reaktivität von Nanopartikeln aufgrund des günstigen Verhältnisses von Oberfläche zu Volumen machen Nanopartikel interessant als Teilbestandteil von Materialien, den sogenannten Nanokompositen.

Neben löslichen nanoskaligen organischen Verbindungen wie Liposome, Mizellen und Vesikel, die ebenfalls unter den Begriff Nanopartikel fallen, sind es aber insbesondere nanoskalige Feststoffpartikel, wie zum Beispiel Partikel aus Oxiden, Metallen oder Halbleitermaterialien, die als Bestandteil von Nanokompositen von Interesse sind. Nanopartikel weisen üblicherweise Abmessungen auf, die sich von Bruchteilen eines Nanometers bis hin zu einigen hundert Nanometern erstrecken können. Obwohl Kohlenstoff-Nanoröhrchen eine Länge von mehreren Mikrometern aufweisen können und damit zumindest in einer räumlichen Dimension den Nanobereich überschreiten, werden auch diese aufgrund ihrer verhältnismäßig sehr geringen Durchmesser zu den Nanopartikeln gezählt, wobei diese als Bestandteil von Nanokompositen eine zunehmende Bedeutung erlangen.

Es sind verschiedene Verfahren zum Herstellen von Nanokomposit-Schichten bekannt. So werden beispielsweise Farben, Lacke und andere Flüssigkeiten mit Nanopartikeln vermischt und mittels Streichen, Spachteln oder Spritzen auf Oberflächen aufgetragen.

Bei unterschiedlichsten Anwendungen ist es üblich, Glasflächen, Folienoberflächen oder auch andere Komponenten im Vakuum zu beschichten. Dafür sind Verfahren der physikalischen Dampfabscheidung sehr weit verbreitet. Zu derartigen Verfahren gehört beispielsweise das Verdampfen, bei dem ein Beschichtungsmaterial zunächst im festen Aggregatzustand vorliegt und durch Wärmezufuhr in den gasförmigen Aggregatzustand überführt wird.

Ein weiteres Verfahren der physikalischen Dampfabscheidung ist das Sputtern. Bei diesem Verfahren wird vor dem Beschichtungsmaterial ein Plasma gezündet. Durch eine geeignete elektrische Beschaltung und die sich daraus ergebenden elektrischen Potentialverhältnisse kommt es zu einem Ionenbeschuss der Beschichtungsmaterialoberfläche, was in der Folge zum Herauslösen von Teilchen aus dem Festkörperverbund führt (Sputtern).

Eine andere Gruppe von Beschichtungstechnologien ist die chemische Dampfabscheidung, welche auch unter dem Kürzel CVD bzw. der Bezeichnung chemical vapour deposition bekannt ist. Bei diesen Verfahren wird eine gasförmige Substanz (auch Monomer genannt) in einen Reaktionsraum eingebracht. Derartige gasförmige Substanzen gehen chemische Reaktionen ein, die zur Schichtbildung führen. Solch eine chemische Reaktion kann beispielsweise durch hohe Temperaturen am Substrat oder durch eine Plasmaanregung ausgelöst werden. Verfahren der plasmaunterstützten chemischen Dampfabscheidung werden auch als PECVD (plasma enhanced chemical vapour deposition) bezeichnet. Weit verbreitet sind PECVD-Verfahren, die mit einem Hochfrequenz- oder Mikrowellenplasma arbeiten.

Eine Zielstellung bei der Anwendung oben genannter Verfahren besteht oftmals darin, homogene Schichten zu erzeugen. Bei einigen Anwendungen können jedoch nur Nanokompositschichten die gewünschten Eigenschaften erreichen. Es sind verschiedene Verfahren für das Herstellen von Nanokompositschichten bekannt.

In WO 2007/045452 wird durch eine Abfolge von Einzelschichten mit wenigen Nanometern Dicke ein Schichtverbund abgeschieden, der in einer räumlichen Dimension, nämlich in Schichtaufwachsrichtung, nanoskalige Veränderungen hinsichtlich Schichtmaterial und somit auch hinsichtlich der Eigenschaften aufweist. Ein anderes Beispiel ist in EP 1 691 606 B1 offengelegt. Dort wird die biozide Wirkung von wenigen Nanometer großen Silberpartikeln beschrieben, die auf einem Substrat abgeschieden und durch eine Siliziumoxidschicht abgedeckt sind, wodurch das Freisetzen von Stoffen mit biozider Wirkung zeitlich gesteuert werden kann. Bei diesen beiden Beispielen basiert das Herstellen einer Nanokompositschicht auf dem zeitlich nacheinander folgenden Abscheiden von Einzelschichten.

Im Unterschied dazu wird in WO 2008/074388 A1 ein Verfahren beschrieben, bei welchem in einem Schritt sowohl biozid wirkende Partikel von wenigen Nanometern Ausdehnung als auch ein diese Partikel einbettendes Material abgeschieden werden, indem das biozid wirkende Material innerhalb einer Vakuumkammer mittels eines Magnetrons zerstäubt wird und gleichzeitig eine plasmaunterstützte chemische Schichtabscheidung auf einem Substrat durch Einlass eines Precursors erfolgt. Die daraus resultierende Schicht weist in allen drei räumlichen Dimensionen nanoskalige Veränderungen bezüglich der Schichtzusammensetzung auf. Bei diesem Verfahren findet die Bildung von Nanopartikeln während des Prozesses selbst statt und ist damit sehr eng mit dem Abscheiden des einbettenden Materials verkoppelt. Ein weiterer Nachteil dieses Verfahrens besteht darin, dass nur Nanokomposite aus Materialien gebildet werden können, die dazu neigen, auf dem Substrat zu agglomerieren, das heißt, sich in kleinen Bereichen zu verklumpen. Diese Eigenschaft ist zwar bei den in WO 2008/074388 A1 beschriebenen Materialien gegeben, ist allerdings nicht auf beliebige andere Materialien übertragbar.

Insbesondere ist es so, dass einige interessante Nanokomposite, die beispielsweise C₆₀-Moleküle enthalten, nur bei hohen Temperaturen hergestellt werden können. Damit ist nicht in jeder Vakuumumgebung die Bildung der Nanopartikel selbst möglich, insbesondere nicht bei der Anwesenheit von Kunststoffsubstraten.

Ein weiteres Verfahren zum Herstellen von Nanokompositen besteht im Verklumpen von Bestandteilen des Ausgangsmaterials im Gasraum bei ausreichend hohem Partialdruck. Jedoch ist auch dieses Verfahren nicht für jede Vakuumumgebung gleichermaßen geeignet. mittels chemischer Schichtabscheidung auf einem erhitzten Substrat abgeschieden wird (WO 2007/051994 A2; HOU X ET AL: Synthesis of Cr2O3-based nanocomposite coatings with incorporation of inorganic fullerene-like nanoparticles "THIN SOLID FILMS, ELSEVIER-SEQUOIA S.A. LAUSANNE, CH, Bd. 516, Nr. 23, 1. Oktober 2008 (2008-10-01), Seiten 8620-8624; HOU X ET AL: "Processing and applications of aerosol-assisted chemical vapor deposition" CHEMICAL VAPOR DEPOSITION 2006 WILEY-VCH VERLAG DE, Bd. 12, Nr. 10, 2006, Seiten 583-596). Ein Nachteil derartiger Verfahren besteht darin, dass hierbei keine Kunststoffsubstrate wegen des Erhitzens der Substrate verwendet werden können.

### Aufgabenstellung

Der Erfindung liegt daher das technische Problem zugrunde, ein Verfahren zum Abscheiden von Nanokomposit-Schichten zu schaffen, mittels dem die Nachteile aus dem Stand der Technik überwunden werden können. Insbesondere soll das Verfahren für eine Vielzahl von Nanopartikelmaterialien und auch für das Abscheiden auf Kunststoffsubstraten geeignet sein.

Die Lösung des technischen Problems ergibt sich durch die Gegenstände mit den Merkmalen des Patentanspruchs 1. Weitere vorteilhafte Ausgestaltungen der Erfindung ergeben sich aus den abhängigen Patentansprüchen.

Das erfindungsgemäße Verfahren beruht auf dem Prinzip der chemischen Schichtabscheidung, bei welchem zumindest ein Ausgangsmaterial für die chemische Reaktion durch einen Einlass in eine Vakuumkammer geführt wird. Dabei wird dieses Ausgangsmaterial gebildet, indem eine Flüssigkeit derart mit Nanopartikeln vermischt wird, dass die Nanopartikel in der Flüssigkeit in dispergierter Form vorliegen. Nach dem Vermischen der Flüssigkeit mit den Nanopartikeln wird dieses Ausgangsmaterial als Aerosol in die Vakuumkammer eingelassen. Unter Aerosol ist im erfindungsgemäßen Sinn ein Sprühnebel, bestehend aus einer Vielzahl von Tröpfchen des Ausgangsmaterials, zu verstehen. Solch ein Sprühnebel kann beispielsweise erzeugt werden, indem das flüssige Ausgangsmaterial mittels eines Trägergases und beispielsweise durch eine Düse in die Vakuumkammer geblasen wird. Alternativ kann das flüssige Ausgangsmaterial auch in einem Gefäß verdampft und auf diese Weise als Dampfwolke in die Vakuumkammer eingelassen werden.

Dadurch, dass in dem Ausgangsmaterial Nanopartikel in dispergierter Form vorliegen, werden beim Erzeugen des Aerosols winzige Tröpfchen geformt, in welche auch Nanopartikel eingeschlossen sind. Weil das Ausgangsmaterial als Aerosol in die Beschichtungszone innerhalb der Vakuumkammer eingelassen wird, erfahren ebenso wie die Tröpfchen des Aerosols auch die in den Tröpfchen eingeschlossenen Nanopartikel eine räumliche Verteilung innerhalb der Beschichtungszone eines zu beschichtenden Substrates. Während des Prozesses der chemischen Schichtabscheidung werden die Nanopartikel dann quasi im Huckepackverfahren mit den am Prozess der chemischen Schichtabscheidung beteiligten Molekülen und Atomen im Schichtmaterial mit eingebunden, wodurch eine Nanokompositschicht entsteht.

Für das Anregen der chemischen Reaktionen zur Schichtabscheidung ist neben einer thermischen Stimulierung der Tröpfchen des Aerosols auch ein Plasma geeignet, welches sich über den Bereich der Beschichtungszone innerhalb der Vakuumkammer erstreckt und somit das Aerosol innerhalb der Beschichtungszone zu einer chemischen Reaktion anregt.

Zum Erzeugen eines Plasmas ist beispielsweise eine Magnetronkonfiguration, bestehend aus einem oder mehreren Magnetrons, geeignet. Dabei können alle aus dem Stand der Technik bekannten Magnetronkonfigurationen zum Erzeugen eines Plasmas, wie beispielsweise Planar-, Rohr- oder Ringmagnetrons, verwendet werden. So kann zum Beispiel mindestens ein Magnetron zumindest zeitweise als Kathode einer Gasentladung geschaltet oder auch zwei Magnetrons abwechselnd als Kathode bzw. Anode einer Gasentladung geschaltet werden. Auch zum Speisen eines Magnetrons können alle hierfür bekannten Stromversorgungseinrichtungen verwendet werden. Beispielsweise kann mindestens ein Magnetron mit einer DC-Stromversorgung oder einer gepulsten DC-Stromversorgung betrieben werden.

Bei einer Ausführungsform wird der Einlass für das Aerosol zumindest im Bereich der Einlassöffnung als Elektrode einer Gasentladung geschaltet. Durch eine solche Anordnung wird gewährleistet, dass sich in der Nähe der Einlassöffnung ein Plasma ausbildet. Da die Dichte des eingelassenen Aerosols in unmittelbarer Umgebung der Einlassöffnung höher ist als im Mittel über dem gesamten Prozessraum, wird die Aktivierung des Aerosols auf diese Weise besonders effektiv und somit eine hohe Abscheiderate realisiert. Bei einer weiteren Ausführungsform sind der Einlass für das Aerosol und ein Magnetron abwechselnd Kathode bzw. Anode einer Gasentladung. Bei dieser Ausführungsform kann das Magnetron zum Beispiel mittels einer Pulspaketstromversorgung betrieben werden.

Als Flüssigkeit für das Ausgangsmaterial sind alle bekannten flüssigen Monomere geeignet, die für eine chemische Schichtabscheidung bei Vakuumbedingungen verwendet werden. Das können beispielsweise metallorganische oder siliziumorganische Verbindungen, wie zum Beispiel HMDSO, TEOS oder Diethylzink sein.

Hinsichtlich des Materials für die Nanopartikel gibt es so gut wie keine Einschränkungen. Die einzige Bedingung bezüglich der Nanopartikel besteht darin, dass sich diese in eine dispergierte Form in die Flüssigkeit untermischen lassen, was für ein jeweiliges Material recht einfach in einem Laborversuch ermittelt werden kann. So können auch Kohlenstoff-Nanoröhrchen als Nanopartikel verwendet werden.

Daher ist das erfindungsgemäße Verfahren einerseits für eine Vielzahl von Nanopartikelmaterialien und andererseits auch für das Beschichten von Kunststoffsubstraten geeignet, weil bei PECVD-Verfahren üblicherweise nicht so ein hoher Energieeintrag in das Substrat erfolgt wie beispielsweise bei PVD-Verfahren.

Wie oben bereits erwähnt, kann das Aerosol innerhalb einer Vakuumkammer gebildet werden, indem das flüssige Ausgangsmaterial mit in dispergierter Form enthaltenden Nanopartikeln mittels eines Trägergases in die Vakuumkammer gesprüht wird. Als Trägergas sind neben Luft auch Edelgase, wie beispielsweise Argon und Helium oder auch Stickstoff geeignet. Wird ein Magnetron als Plasma erzeugende Einrichtung verwendet, ist es besonders vorteilhaft, wenn Argon als Trägergas für das Aerosol verwendet wird, weil das Argon gleichzeitig als Arbeitsgas für das Erzeugen des Magnetronplasmas verwendet werden kann.

Hauptsächlich wird ein Magnetron beim erfindungsgemäßen Verfahren zum Erzeugen des Plasmas verwendet. Ein Sputterabtrag am zugehörigen Target und somit eine Beteiligung abgetragener Sputterteilchen am Schichtaufbau ist kein zwingendes Merkmal des Verfahrens. Soll ein Magnetron nur zum Erzeugen eines Plasmas verwendet werden, dann sind als Target solche Materialien mit geringer Sputterausbeute, wie zum Beispiel Titan, zu wählen. Alternativ besteht jedoch auch die Möglichkeit das Material des zum Magnetron gehörenden Targets so auszuwählen, dass Targetmaterial mit am Schichtaufbau beteiligt wird, wodurch die Kompositstruktur des Schichtmaterials beeinflusst werden kann.

Neben dem Trägergas für das Aerosol können auch noch weitere Gase, wie Arbeitsgase für ein Magnetronplasma, Reaktivgase wie beispielsweise Sauerstoff oder andere Gase zum Dotieren des Schichtmaterials durch einen gemeinsamen oder einen separaten Einlass in die Vakuumkammer eingelassen werden.

Dadurch, dass das Material der in die Nanokompositschicht eingebetteten Nanopartikel nahezu unbeschränkt ist, lässt sich das erfindungsgemäße Verfahren zum Abscheiden von Nanokompositschichten mit unterschiedlichsten Funktionen einsetzen. So können erfindungsgemäß beispielsweise elektrisch leitfähige Schichten, UV-absorbierende Schichten oder mechanische Schutzschichten abgeschieden werden.

### Ausführungsbeispiel

Die Erfindung wird nachfolgend anhand eines bevorzugten Ausführungsbeispiels näher erläutert. Die einzige Figur zeigt eine schematische Darstellung einer Vorrichtung zum Ausführen des erfindungsgemäßen Verfahrens.

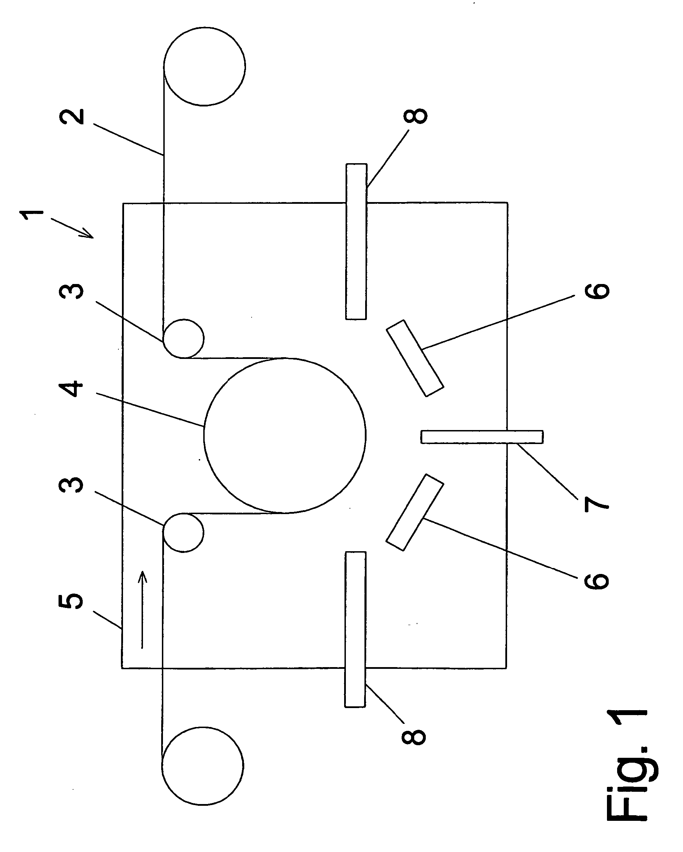

In Fig.1 ist eine Vorrichtung 1 schematisch dargestellt, bei der ein als PET-Folie ausgebildetes Substrat 2 über zwei Umlenkrollen 3 und eine Kühlwalze 4 durch eine Vakuumkammer 5 geführt wird. In einem in Fig. 1 nicht dargestellten Gefäß werden Diethylzink und Kohlenstoff-Nanoröhren derart zu einer Nanosuspension vermischt, dass die Kohlenstoff-Nanoröhrchen im Diethylzink in dispergierter Form vorliegen. Dabei beträgt der Anteil der Kohlenstoff-Nanoröhren an der Suspension zwischen einem und fünf Gewichtsprozent.

Mittels einer Doppelmagnetronanordnung 6 wird innerhalb einer Beschichtungszone zwischen der Doppelmagnetronanordnung 6 und der Kühlwalze 4 ein Magnetronplasma erzeugt. Beide Magnetrons weisen eine Targetoberfläche von 350 mm x 125 mm auf und werden mit einer elektrischen Leistung von 2 kW bipolar gespeist.

Durch eine Einlassdüse 7 werden sowohl die Nanosuspension mit einer Menge von 20 g/h als auch das Gas Argon mit 200 sccm in die Vakuumkammer 5 eingelassen, wodurch sich die Nanosuspension als Sprühnebel in der Vakuumkammer ausbreitet, wobei der Sprühnebel insbesondere in der Beschichtungszone der Einwirkung des Magnetronplasmas ausgesetzt ist. Mittels zweier Zuführungsleitungen 8 wird gleichzeitig noch Sauerstoff mit insgesamt 200 sccm in die Vakuumkammer 5 eingelassen.

Aufgrund der Einwirkung des Plasmas auf den Sprühnebel wird das darin befindliche Diethylzink aufgespalten und die aufgespaltenen Moleküle und Atome zu chemischen Reaktionen, insbesondere mit dem in die Vakuumkammer 5 eingelassenen Sauerstoff und der Substratoberfläche angeregt. So reagiert zum einen das im Diethylzink enthaltene Zink mit Sauerstoff und scheidet sich als Zinkoxid auf der Substratoberfläche ab. Gleichzeitig mit den Sprühnebeltröpfchen gelangen auch die Kohlenstoff-Nanoröhrchen zur Substratoberfläche und werden in das sich abscheidende Zinkoxid mit eingelagert. Weiterhin reagiert der Sauerstoff mit Etyhlmolekülen des Diethylzink zu flüchtigen organischen Verbindungen, die größtenteils über die Pumpen zum Aufrechterhalten des Kammervakuums abgepumpt werden. Einige der entstehenden organischen Verbindungen werden aber auch als Schichtmaterial abgeschieden.

Auf diese Weise wird auf dem Substrat 2 eine Nanokompositschicht abgeschieden, die überwiegend aus Zinkoxid mit eingelagerten Kohlenstoff-Nanoröhrchen besteht und die auch einen Anteil an organischen Verbindungen aufweist. Je mehr Sauerstoff in die Vakuumkammer eingelassen wird, umso weniger organische Verbindungen weist die Nanokompositschicht auf, weil dann mehr flüchtige organische Verbindungen entstehen, die aus der Kammer abgepumpt werden. Mit der zugeführten Sauerstoffmenge lässt sich somit der Reinheitsgrad der Nanokompositschicht einstellen, wenn es darauf ankommt, möglichst wenig organische Verbindungsbestandteile als Schichtmaterial abzuscheiden.

Die abgeschiedene Nanokompositschicht weist eine gute elektrische Leitfähigkeit auf, die hauptsächlich aus den eingebetteten Kohlenstoff-Nanoröhrchen resultiert. Zwischen den einzelnen Kohlenstoff-Nanoröhrchen erfolgt die Weiterleitung elektrischer Ladungsträger durch das Zinkoxid. Vorteilhafterweise können daher auch noch weitere Reaktivgase in die Vakuumkammer 5 eingelassen werden, mit welchen das Zinkoxid dotiert wird, wodurch die elektrische Leitfähigkeit des Zinkoxids weiter verbessert werden kann.

Das Ausführungsbeispiel wurde anhand von Kohlenstoff-Nanoröhrchen als Nanopartikel und anhand einer abgeschiedenen elektrisch leitfähigen Nanokompositschicht beschrieben. Wie bereits oben erwähnt ist das erfindungsgemäße Verfahren nicht auf diese beispielhaften Merkmale beschränkt, sondern mit dem erfindungsgemäßen Verfahren können alle Materialien, die auf Nanopartikelgröße skalierbar sind, abgeschieden und dadurch auch Nanokompositschichten mit anderen Funktionen wie beispielsweise einer UV-absorbierenden Funktion oder einer mechanischen Schutzwirkung realisiert werden.

## Patentansprüche

1. Verfahren zum Abscheiden einer Nanokomposit-Schicht auf einem Substrat (2) mittels einer chemischen Reaktion innerhalb einer Vakuumkammer (5), wobei zumindest ein Ausgangsmaterial der chemischen Reaktion durch einen Einlass (7) in die Vakuumkammer (5) geführt und das Ausgangsmaterial gebildet wird, indem eine Flüssigkeit derart mit Nanopartikeln vermischt wird, dass die Nanopartikel in der Flüssigkeit in dispergierter Form vorliegen und dass das Ausgangsmaterial als Aerosol in die Vakuumkammer (5) eingelassen wird, **dadurch gekennzeichnet, dass** in der Vakuumkammer (5) ein Plasma erzeugt wird, indem mindestens ein Magnetron (6) zumindest zeitweise als Kathode einer Gasentladung und der Einlass (7) zumindest im Bereich der Einlassöffnung zumindest zeitweise als Anode einer Gasentladung geschaltet werden.

2. Verfahren nach Anspruch 1, **dadurch gekennzeichnet, dass** zwei Magnetrons (6) abwechselnd als Kathode und zugehörige Anode einer Gasentladung geschaltet werden.

3. Verfahren nach Anspruch 1 oder 2, **dadurch gekennzeichnet, dass** mindestens ein Magnetron mit einer DC-Stromversorgung oder einer gepulsten DC-Stromversorgung betrieben wird.

4. Verfahren nach einem der vorhergehenden Ansprüche, **dadurch gekennzeichnet, dass** zumindest ein Magnetron und der Einlass abwechselnd als Kathode und zugehörige Anode einer Gasentladung betrieben werden, wobei das Magnetron mittels einer Pulspaketstromversorgung betrieben wird.

5. Verfahren nach einem der vorhergehenden Ansprüche, **dadurch gekennzeichnet, dass** neben dem Ausgangsmaterial für die chemische Reaktion ein weiteres Gas durch den Einlass in die Vakuumkammer geführt wird.

6. Verfahren nach einem der vorhergehenden Ansprüche, **dadurch gekennzeichnet, dass** das Ausgangsmaterial mit einem Trägergas in die Vakuumkammer eingelassen wird.

7. Verfahren nach Anspruch 6, **dadurch gekennzeichnet, dass** ein Edelgas als Trägergas verwendet wird.

8. Verfahren nach Anspruch 7, **dadurch gekennzeichnet, dass** Argon als Trägergas verwendet wird.

9. Verfahren nach einem der vorhergehenden Ansprüche, **dadurch gekennzeichnet, dass** eine metallorganische oder siliziumorganische Verbindung als Flüssigkeit verwendet wird.

10. Verfahren nach einem der vorhergehenden Ansprüche, **dadurch gekennzeichnet, dass** Kohlenstoff-Nanoröhrchen als Nanopartikel verwendet werden.

## Claims

1. Process for depositing a nanocomposite layer on a substrate (2) by means of a chemical reaction in a vacuum chamber (5), where at least one starting material of the chemical reaction is introduced through an inlet (7) into the vacuum chamber (5) and the starting material is formed by a liquid being mixed with nanoparticles in such a way that the nanoparticles are dispersed in the liquid and that the starting material is introduced into the vacuum chamber (5) as an aerosol, **characterized in that** a plasma is generated in the vacuum chamber (5) by at least one magnetron (6) being connected for at least a part of the time as the cathode of a gas discharge and the inlet (7) being connected for at least a part of the time as the anode of a gas discharge at least in the region of the inlet opening.

2. Process according to Claim 1, **characterized in that** two magnetrons (6) are connected alternately as cathode and associated anode of a gas discharge.

3. Process according to Claim 1 or 2, **characterized in that** at least one magnetron is operated with a DC power supply or a pulsed DC power supply.

4. Process according to any of the preceding claims, **characterized in that** at least one magnetron and the inlet are operated alternately as cathode and associated anode of a gas discharge, with the magnetron being operated by means of a pulse packet power supply.

5. Process according to any of the preceding claims, **characterized in that** a further gas in addition to the starting material for the chemical reaction is introduced through the inlet into the vacuum chamber.

6. Process according to any of the preceding claims, **characterized in that** the starting material is admitted together with a carrier gas into the vacuum chamber.

7. Process according to Claim 6, **characterized in that** a noble gas is used as carrier gas.

8. Process according to Claim 7, **characterized in that** argon is used as carrier gas.

9. Process according to any of the preceding claims, **characterized in that** a metal-organic or silicon-organic compound is used as liquid.

10. Process according to any of the preceding claims, **characterized in that** carbon nanotubes are used as nanoparticles.

## Revendications

1. Procédé de dépôt d'une couche de nanocomposite sur un substrat (2) au moyen d'une réaction chimique à l'intérieur d'une chambre (5) sous vide,
au moins un matériau de départ de la réaction chimique étant amené dans la chambre (5) sous vide par une admission (7) et le matériau de départ étant formé en mélangeant un liquide avec des nanoparticules de telle sorte que les nanoparticules soient présentes dans le liquide sous forme dispersée,
le matériau de départ étant admis dans la chambre (5) sous vide sous la forme d'un aérosol, **caractérisé en ce que**
un plasma est formé dans la chambre (5) sous vide en branchant au moins un magnétron (6) au moins une partie du temps comme cathode de décharge dans un gaz et en branchant l'admission (7) au moins une partie du temps comme anode de décharge dans un gaz au moins au niveau de l'ouverture d'admission.

2. Procédé selon la revendication 1, **caractérisé en ce que** deux magnétrons (6) sont commutés en alternance comme cathodes et anodes associées de décharge dans un gaz.

3. Procédé selon les revendications 1 ou 2, **caractérisé en ce qu'**au moins un magnétron est conduit avec une alimentation en courant continu ou une alimentation en courant continu pulsé.

4. Procédé selon l'une des revendications précédentes, **caractérisé en ce qu'**au moins un magnétron et l'admission sont conduits en alternance comme cathodes et comme anodes associées de décharge dans un gaz, le magnétron étant alimenté en courant pulsé par paquets.

5. Procédé selon l'une des revendications précédentes, **caractérisé en ce qu'**en plus du matériau de départ de la réaction chimique, un autre gaz est amené dans la chambre sous vide par l'admission.

6. Procédé selon l'une des revendications précédentes, **caractérisé en ce que** le matériau de départ est admis dans la chambre sous vide avec un gaz porteur.

7. Procédé selon la revendication 6, **caractérisé en ce qu'**il utilise un gaz rare comme gaz porteur.

8. Procédé selon la revendication 7, **caractérisé en ce qu'**il utilise de l'argon comme gaz porteur.

9. Procédé selon l'une des revendications précédentes, **caractérisé en ce qu'**il utilise comme liquide un composé organométallique ou un composé organique du silicium.

10. Procédé selon l'une des revendications précédentes, **caractérisé en ce qu'**il utilise comme nanoparticules des nanotubes de carbone.
